# EUROPEAN PATENT APPLICATION

(11) **EP 2 908 147 A1**
(43) Date of publication of application: **19.08.2015**
(21) Application number: 14155223.2
(22) Date of filing: 14.02.2014
(51) Int. Cl.: G01R 31/28

(54) **Method and apparatus for testing ic devices including temperature verification**

(71) Applicant: Rasco GmbH, 83059 Kolbermoor (DE)
(72) Inventor: Schöttl, Thomas, 83075 Bad Feilnbach (DE)
(74) Representative: Grünecker Patent- und Rechtsanwälte PartG mbB

(57) **Abstract**

The invention provides a method of feeding integrated circuit devices to a test site of a handling system for handling integrated circuit devices, comprising the steps of: temperature conditioning integrated circuit devices in a buffer region of the handling system for a predetermined first time interval; measuring the temperature of an integrated circuit device in the buffer region after the predetermined first time interval has elapsed; and releasing the integrated circuit device for testing, if the measured temperature is within a predetermined temperature range. The invention further provides a handling system comprising: means for temperature conditioning integrated circuit devices in a buffer region of the handling system for a predetermined first time interval; means for measuring the temperature of an integrated circuit device in the buffer region after the predetermined first time interval has elapsed; and means for releasing the integrated circuit device for testing, if the measured temperature is within a predetermined temperature range.

## Description

### Field of the Invention

The present invention relates to a method of feeding integrated circuit devices to a test site of a test system for testing integrated circuit devices and a corresponding apparatus therefore.

### Prior Art

For testing the quality of integrated circuits devices (ICs) an automatic test system having a test site for contacting an IC with test electronics may be used to decide on the proper function of the IC. Based on the test results, the ICs may be sorted to make them available for packaging or other applications. Specific tests of ICs for automotive purposes, for example, relate to testing the function of the ICs at high and low temperatures (e.g. in the range of -60°C to +175°C).

The above-mentioned test system may involve the use of an IC Test Handler (e.g. a test-in-strip handler, a turret handler, a pick-and-place handler or a gravity handler). In a strip handler a plurality of ICs are provided on a single strip and may tested simultaneously. In a pick-and-place handler the ICs are picked up and placed onto a test site. In case of a gravity handler, the ICs are arranged in a generally vertical guiding rail so that the ICs are transported by their own gravity, and the ICs are released one after the other to the test site at the end of the guiding rail. Moreover, the guiding rail is temperature conditioned, for example heated to a particular temperature, so that the ICs which are in direct contact with the guiding rail are heated and asymptotically approach the temperature of the guiding rail while they are transported to the test site. Alternatively, the ICs may be heated using temperature conditioned air that is ventilated to the ICs or that passes the ICs by convection.

During the transportation in the guide rail, however, once in a while the contact between an IC and the guide rail may not be ideal.

Often it is not known how long it takes for a particular IC to attain a particular temperature. According to the prior art method, the so called "soaking time" of the ICs is adjusted such that all ICs have a temperature that is within a predefined range (i.e. having less than a given deviation from a set temperature), even if non-ideal contacts occur. The soaking time may thus be defined as the time that the ICs are temperature conditioned, in order to attain a temperature in the desired range. Particularly for safety relevant applications such as in the automotive sector a procedure is adopted to be definitely sure that the test is performed with an IC at a known temperature by using a soaking time is for example a safety factor of 2 or more too large. This has the disadvantage that the test speed must be reduced in favour of temperature conditioning time, although most of the ICs reach the desired temperature range in a much shorter time.

### Description of the Invention

The problem underlying the present invention in view of the prior art is to increase the throughput of such a handling system for IC devices tested in tempered environment by avoiding a soaking time safety margin.

The above-mentioned problem is solved by the method according to claim 1.

According to the invention a method of feeding integrated circuit devices to a test site of a handling system for handling integrated circuit devices is provided, comprising the steps of: temperature conditioning integrated circuit devices in a buffer region of the handling system for a predetermined first time interval; measuring the temperature of an integrated circuit device in the buffer region after the predetermined first time interval has elapsed; and releasing the integrated circuit device for testing, if the measured temperature is within a predetermined temperature range. Therefore, there is no need for a safety margin regarding the soaking time, since the temperature of an integrated circuit is measured and the integrated circuit can be released immediately for testing when the desired temperature has been attained.

The method of feeding integrated circuit devices to a test site of a test system for testing integrated circuit devices according to the invention may comprise the steps of moving integrated circuit devices to a test site in a sequence; temperature conditioning the integrated circuit devices while being moved in the sequence; measuring the temperature of each integrated circuit device at a predetermined position of the sequence; and advancing the sequence, if the measured temperature is within a predetermined temperature range. The predetermined position in the sequence relates to a location fixed with respect to the test system where the ICs eventually pass one after the other when advanced in the sequence.

The method according to the invention has the advantage that the soaking time can be decreased to a value that corresponds to the case when there is good thermal contact during the temperature conditioning, as it is for the majority of the ICs. Only when the measurement reveals that the particular IC has not yet reached the desired temperature (range), the soaking time may be increased.

The inventive method can be developed such that it may comprise the further step of waiting for a predetermined time before advancing the sequence, if the measured temperature is not within the predetermined temperature range. Hence, a waiting time is introduced such that the particular IC can obtain a desired temperature (range). For example, this time may be chosen such as to be the same as the regular time interval within the guide rail that is used according to the prior art. However, due to the fact that this is an exceptional situation, the overall throughput is increased anyway.

According to another development, the method may comprise the additional step of performing a further step of measuring the temperature of the integrated circuit device after a predetermined period of time, if the initially measured temperature is not within the predetermined temperature range, and advancing the sequence, if the further measured temperature is within the predetermined temperature range. Accordingly, the waiting time for the particular IC can be reduced, since a further measurement of the temperature is performed. In case the desired temperature is measured in the second measurement, the sequence may proceed. Otherwise, another waiting and measuring cycle may be implemented.

Alternatively, a continuous measurement of the temperature can be used, so that the sequence is advanced when the temperature is within the particular predefined range. This procedure limits the soaking time to a minimum and hence increases the throughput to a maximum.

According to a further development, the method may comprise the step of releasing the or an integrated circuit device at an end of the sequence so as to be moved to the test site, in particular, wherein the sequence is advanced by releasing the integrated circuit device at the end of the sequence. At the end of the sequence, the IC which temperature has currently been measured may be released to the test site, or alternatively, one or more ICs may still be in between the temperature measuring position and the release position. Accordingly, the temperature measurement may be performed at the end of the sequence or at a position corresponding to a particular number of ICs before the end, for example at the penultimate or antepenultimate position.

According to a further development, the method may comprise the further steps of adding one or more integrated circuit device or a strip of IC devices at a beginning of the sequence, when the sequence is advanced. Accordingly, the length of the sequence is maintained (number of ICs in the sequence) and a continuous testing may be performed.

According to a further development, the step of temperature conditioning the integrated circuit devices may comprise the step of contacting the integrated circuit devices with means for guiding the integrated circuit devices, and conditioning the guiding means at a set temperature, or the step of providing temperature-conditioned air to the integrated circuit devices. This is a particular convenient method to condition the ICs in a gravity handler. Alternatively, the ICs may be conditioned by using temperature conditioned air surrounding the ICs.

According to a further development, the integrated circuit devices in the sequence are arranged at differing heights and move in the sequence by gravity. Hence, the transport / moving of the ICs is initiated by their own weight.

Alternatively, the integrated circuit devices in the sequence may be moved actively, for example by means of an actuator. In this case the sequence may be arranged horizontally.

The above-mentioned problem is further solved by the handling system for handling integrated circuit devices to be tested according to claim 9.

The handling system according to the invention comprises: means for temperature conditioning integrated circuit devices in a buffer region of the handling system for a predetermined first time interval; means for measuring the temperature of an integrated circuit device in the buffer region after the predetermined first time interval has elapsed; and means for releasing the integrated circuit device for testing, if the measured temperature is within a predetermined temperature range.

The test system for testing integrated circuit components according to the invention may in particular comprise means for guiding integrated circuit devices to a test site in a sequence; means for temperature conditioning the integrated circuit devices while being moved in the sequence; means for measuring the temperature of each integrated circuit device at a predetermined position of the sequence; and means for advancing the sequence, if the measured temperature is within a predetermined temperature range.

The test system may further comprise means for guiding integrated circuit devices comprises a guiding rail.

In the test system, the means for temperature conditioning the integrated circuit devices may comprise means for heating and / or means for cooling the guiding rail.

The means for measuring the temperature may comprise a temperature sensor, in particular a resistance temperature detector, a thermistor configured to temporarily contact the integrated circuit device, or an infrared sensor.

The test system may further comprise means for releasing the integrated circuit device for it to be moved to the test site, in particular, wherein means for releasing the integrated circuit device also functions as the means for advancing the sequence.

The test system may further comprise means for adding an integrated circuit device at a beginning of the sequence, when the sequence is advanced.

In the test system the means for guiding integrated circuit devices may be configured to arrange the integrated circuit devices in the sequence at differing heights and to move the integrated circuit devices in the sequence by gravity. However, the IC devices may alternatively be moved actively by an actuator for example in the horizontal direction.

The advantages of the test system and its developments correspond to the advantages given above for the method according to the inventions and its developments.

Further features and advantages of the present invention will be described in the following with reference to the figures, which illustrate only examples of embodiments of the present invention. The illustrated and described features may be suitably combined with each other.

### Brief Description of the Drawings

- Fig. 1: illustrates an embodiment of the handling system according to the invention.
- Fig. 2: illustrates another embodiment of the handling system according to the invention.

### Description of the Embodiments

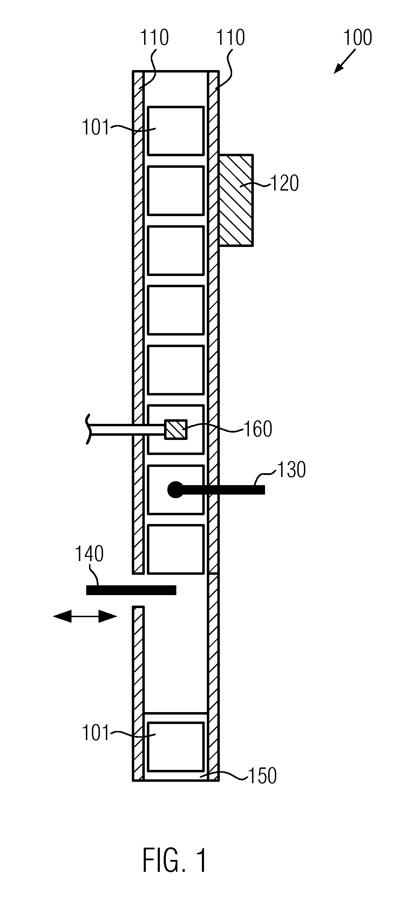

Figure 1 shows an embodiment of the handling system according to the invention. The handling system 100 for testing integrated circuit components 101 according to the invention comprises means 110 for guiding integrated circuit devices 101 to a test site 150 in a sequence; means 120 for temperature conditioning the integrated circuit devices while being moved in the sequence; means 160 for measuring the temperature of each integrated circuit device at a predetermined position of the sequence; and means 130, 140 for advancing the sequence, if the measured temperature is within a predetermined temperature range.

In this embodiment the means 110 for guiding the integrated circuit devices 101 is a guiding rail arranged vertically. The last IC of the sequence of ICs is stopped by the stopper 140 and the column of the remaining ICs is fixed by the holder 130 by holding the penultimate IC. After a first measurement of the temperature of the IC in the antepenultimate position (as it is in this example, but it may as well be the last or the penultimate IC of the sequence) the sequence is advanced when the measured temperature is within a predefined range (the pin 140 is retracted to release the last IC and reinserted, and thereafter the holder 130 being released for a short time to allow the whole sequence to advance by one IC).

In case the measurement with the temperature sensor 160 reveals that the temperature of the IC does not yet fall in the desired range, a waiting cycle involving a particular period of time is performed. After the waiting cycle, the pin 140 may be retracted without further temperature measurement, or a second measurement of the temperature of the currently temperature checked IC may be implemented, with another waiting cycle, if necessary.

Alternatively, it the first measurement has the result that the measured temperature is not within the predefined range, the temperature of the particular IC may be then continuously monitored until the temperature of the IC has changed to be within this range.

The sequence as shown in Figure 1 may also be considered as being arranged in the horizontal direction, so that the Figure is representing a top view. In that case the elements 130 and 140 are not required, however, an actuator (not shown) for moving the ICs in the sequence may for example be provided at the entrance opening of the guiding means 110. For example the whole sequence may be moved by the distance between adjacent ICs if the temperature measured by sensor 160 is within the desired temperature range.

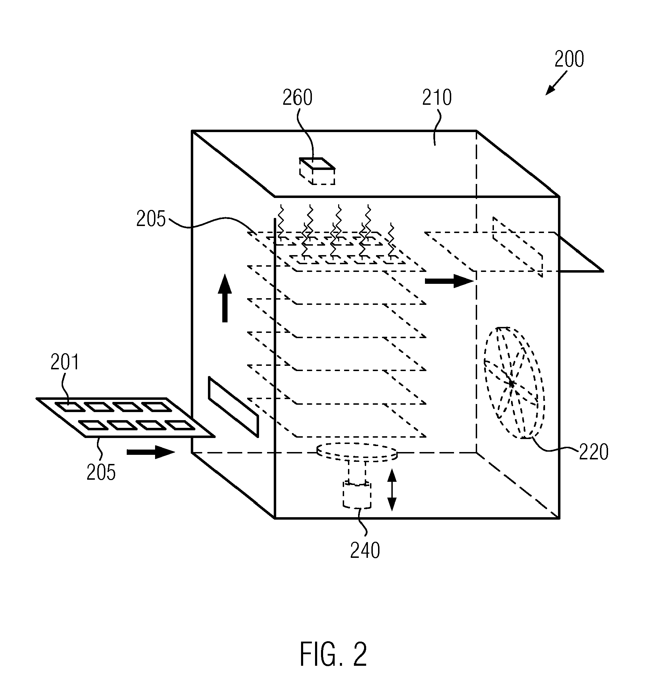

Figure 2 shows another embodiment of the handling system according to the invention. The handling system 200 is configured to handle strips or carriers 205 including a plurality of ICs 201 thereon in a housing 210. In this embodiment the strips or carriers 205 enter the housing 210 at a lower part thereof, are moved upwards by an actuator 240 as the means for advancing the ICs and exit the housing 210 at an upper part thereof for being tested. The means for temperature conditioning the integrated circuit devices in this embodiment includes a ventilator 220 to circulate temperature conditioned air over the ICs. The means for measuring the temperature of an integrated circuit device 201 or each of the ICs 201 in this embodiment is realized as an infrared sensor 260 that converts the measured infrared radiation into a corresponding temperature. Although this embodiment involves a vertical motion of the strips or carriers 205, they may alternatively move in an inclined or horizontal direction.

## Claims

1. A method of feeding integrated circuit devices to a test site of a handling system for handling integrated circuit devices, comprising the steps of:
temperature conditioning integrated circuit devices in a buffer region of the handling system for a predetermined first time interval;
measuring the temperature of an integrated circuit device in the buffer region after the predetermined first time interval has elapsed; and
releasing the integrated circuit device for testing, if the measured temperature is within a predetermined temperature range.

2. The method of claim 1,
wherein the step of temperature conditioning the integrated circuit devices in the buffer region for the predetermined first time interval comprises the steps of:
moving the integrated circuit devices to the test site in a sequence; and
temperature conditioning the integrated circuit devices while being moved in the sequence;
wherein the step of measuring the temperature of an integrated circuit device in the buffer region after the predetermined first time interval has elapsed comprises the step of:
measuring the temperature of the integrated circuit device in the sequence at a predetermined position of the sequence; and
wherein the step of releasing the integrated circuit device for testing comprises the step of:
advancing the sequence.

3. The method of claim 1 or 2, comprising the further step of waiting for a predetermined second time interval, if the measured temperature is not within the predetermined temperature range.

4. The method of claim 1 or 2, comprising the additional step of performing a further step of measuring the temperature of the integrated circuit device after a predetermined second time interval, if the initially measured temperature is not within the predetermined temperature range.

5. The method of claim 1 or 2, wherein the step of measuring the temperature is performed continuously, in particular after the initially measured temperature is not within the predetermined temperature range.

6. The method of one of claims 1 to 5, wherein the step of temperature conditioning the integrated circuit devices comprises contacting the integrated circuit devices with means for guiding the integrated circuit devices, and conditioning the guiding means at a set temperature and/or conditioning air surrounding the integrated circuits at the set temperature.

7. The method of one of claims 1 to 6, wherein the integrated circuit devices in the sequence are at differing heights and move in the sequence by gravity.

8. The method of one of claims 1 to 6, wherein the integrated circuit devices are moved by an actuator.

9. Handling system for handling integrated circuit devices to be tested, the handling system comprising:
means for temperature conditioning integrated circuit devices in a buffer region of the handling system for a predetermined first time interval;
means for measuring the temperature of an integrated circuit device in the buffer region after the predetermined first time interval has elapsed; and
means for releasing the integrated circuit device for testing, if the measured temperature is within a predetermined temperature range.

10. The handling system of claim 9, further comprising:
means for guiding integrated circuit devices to a test site in a sequence;
wherein the means for temperature conditioning the integrated circuit devices comprises means for temperature conditioning the integrated circuit devices while being moved in the sequence;
wherein the means for measuring the temperature of an integrated circuit device comprises means for measuring the temperature of an integrated circuit device at a predetermined position of the sequence; and
wherein the means for releasing the integrated circuit device for testing comprises means for advancing the sequence, if the measured temperature is within a predetermined temperature range.

11. The handling system according to claim 10, wherein the means for guiding integrated circuit devices comprises a guiding rail.

12. The handling system according to claim 10 or 11, wherein the means for temperature conditioning the integrated circuit devices comprises means for heating and / or means for cooling the guiding means, or wherein the means for temperature conditioning the integrated circuit devices comprises means for providing temperature conditioned gas to the integrated circuit devices.

13. The handling system according to one of claims 9 to 12, wherein the means for measuring the temperature comprises a temperature sensor, in particular a resistance temperature detector or a thermistor, configured to temporarily contact the integrated circuit device, or wherein the means for measuring the temperature comprises an infrared sensor.

14. The handling system according to one of claims 10 to 13, wherein the means for guiding integrated circuit devices are configured to arrange the integrated circuit devices in the sequence at differing heights and to move the integrated circuit devices in the sequence by gravity.

15. The handling system according to one of claims 10 to 13, wherein the means for guiding integrated circuit devices comprise an actuator for moving the integrated circuit devices in the sequence.
